# EUROPÄISCHE PATENTSCHRIFT

(11) **EP 0 565 204 B1**
(45) Veröffentlichungstag und Bekanntmachung des Hinweises auf die Patenterteilung: **07.07.1999**
(21) Anmeldenummer: 93201023.4
(22) Anmeldetag: 07.04.1993
(51) Int. Cl.: G01R 15/04

(54) **Hochspannungseinheit mit einer Messteiler-Widerstandsanordnung**
High voltage unit with measuring divider using resistors
Unité haute tension avec un diviseur de mesure à résistances

(30) Priorität: 09.04.1992 DE 4211944
(43) Veröffentlichungstag der Anmeldung: 13.10.1993
(73) Patentinhaber: Philips Patentverwaltung GmbH, 22335 Hamburg (DE); Koninklijke Philips Electronics N.V., 5621 BA Eindhoven (NL)
(72) Erfinder: Freiheit-Jensen, Bernd, c/o Philips Patentverwalt., W-2000 Hamburg 1 (DE); Lunding, Arne, c/o Philips Patentverwaltung, W-2000 Hamburg 1 (DE); Negle, Hans, c/o Philips Patentverwaltung, W-2000 Hamburg 1 (DE)
(74) Vertreter: Hartmann, Heinrich, Dipl.-Ing.

(56) Entgegenhaltungen:
- EP-A- 0 118 147
- EP-A- 0 382 274
- DE-A- 3 714 945
- DE-B- 2 833 036

## Beschreibung

Die Erfindung betrifft eine Hochspannungseinheit nach dem Oberbegriff des Anspruchs 1. Aus der DE-A 37 14 945 ist ein Hochspannungsmeßteiler zum Messen von Hochspannungen in mittel- und hochfrequenten Röntgengeneratoren bekannt, der zwei an die zu messende Hochspannung anzuschließende zueinander parallele Hochspannungselektroden umfaßt, zwischen denen eine dazu parallel flächenhafte Meßelektrode angeordnet ist. Zwischen dieser Meßelektrode und einer der Hochspannungselektroden ist eine Meßteiler-Widerstandsanordnung geschaltet, die aus einem induktivitätsfreien, mäanderförmig aufgebauten Widerstand besteht und schräg zu den Elektroden verläuft. Dieser Hochspannungsmeßteiler ist zum Einbau in eine Hochspannungseinheit - an einer Stelle wo ihn das zu messende Hochspannungspotential umgibt - vorgesehen. Daraus ist somit eine Hochspannungseinheit der eingangs genannten Art bekannt.

Weiterhin ist aus der EP-A 118 147 eine Hochspannungseinheit in Form eines Hochspannungserzeugers für einen Röntgengenerator bekannt. Die Meßteiler-Widerstandsanordnung ist dabei Teil eines Hochspannungsmeßteilers, der außer der Meßteiler-Widerstandsanordnung einen Fußpunkt-Widerstand umfaßt. Der Abgriff dieses Hochspannungsteilers bildet den Meßpunkt, und die an diesem Meßpunkt abgegriffene Spannung von einigen Volt muß in einem Frequenzbereich von Null bis einigen hundert Khz möglichst exakt der Hochspannung proportional sein. Die Meßteiler-Widerstandsanordnung wird von einem an die Hochspannung angeschlossenen Dämpfungswiderstand umschlossen. Dabei ergeben sich relativ große parasitäre Kapazitäten. Um Verfälschungen der Meßspannung aufgrund dieser parasitären Kapazitäten zu vermeiden, sind den in Serie geschalteten Widerständen, aus denen die Meßteiler-Widerstandsanordnung aufgebaut ist, Kondensatoren parallel geschaltet. Diese Kondensatoren, die je nach Zahl der Widerstände in der Meßwiderstandsanordnung für einen mehr oder weniger großen Teil der Hochspannung ausgelegt sein müssen, sind teuer und gegen Hochspannungsstörungen empfindlich.

Baut man einen derartigen Spannungsteiler in einen Hochspannungserzeuger ein, dann muß zwischen den außen liegenden Hochspannungselektroden und den geerdeten Teilen in dem Hochspannungserzeuger - beispielsweise dem aus Metall bestehenden Hochspannungserzeugergehäuse - ein ausreichend großer Abstand bestehen, damit Überschläge vermieden werden. Dadurch ergibt sich ein relativ großer Einbauraum. Außerdem entstehen an den Kanten der Hochspannungselektroden hohe elektrische Feldstärken.

Aufgabe der vorliegenden Erfindung ist es, eine Hochspannungseinheit der eingangs genannten Art so auszubilden, daß sich ein kompakter Aufbau ergibt, und eine genaue Messung der Hochspannung in einem großen Frequenzbereich möglich wird. Diese Aufgabe wird durch die im Anspruch 1 angegebenen Maßnahmen gelöst.

Bei der Erfindung bildet also eine in der Hochspannungseinheit ohnehin vorhandene Hochspannungselektrode einen Teil des Hochspannungsmeßteilers. Diese Doppelfunktion der Hochspannungselektrode verringert die Kosten, und darüberhinaus erfordert der Einsatz dieser Elektrode für den Meßteiler keinen zusätzlichen Bauraum. Da das Meßelektrodenpotential sich nur wenig vom Erdpotential unterscheidet, sind zumindest im Bereich der Meßelektroden keine zusätzlichen Isolationsstrecken erforderlich, was den Bauraum noch weiter verkleinert.

Die Hochspannungseinheit kann z.B. ein Hochspannungserzeuger, ein Hochspannungsverbraucher, ein Hochspannungsumschalter oder ein Hochspannungsstecker an einem Kabel für invasive Hochspannungsmessungen sein.

Als Hochspannungselektrode kann jede beliebige Hochspannungselektrode in der Hochspannungseinheit dienen, soweit sie nur eine längliche Form hat, beispielsweise ein Hochspannungskabel, eine leitende Hochspannungsverbindung oder ähnliches. An diesen Komponenten ergibt sich im Betriebszustand kein Spannungsabfall. Es können jedoch auch Komponenten als Hochspannungselektrode dienen, die einen gewissen Spannungsabfall aufweisen, z.B. ein Hochspannungs-Dämpfungswiderstand. Der Begriff Elektrode muß daher in Zusammenhang mit der Erfindung weit aufgefaßt werden.

Eine bevorzugte Ausgestaltung der Erfindung, die von einer Hochspannungseinheit mit wenigstens einer Hochspannungssteckverbindung zum Anschluß eines Hochspannungskabels einer Hochspannungseinheit ausgeht, sieht vor, daß die Meßteiler-Widerstandsanordnung sich zwischen der Hochspannungssteckverbindung und der Meßelektrode befindet. Hier dient also die Hochspannungssteckverbindung mit dem darin befindlichen Leiter als Hochspannungselektrode.

In weiterer Ausgestaltung der Erfindung ist vorgesehen, daß ein Isolierteil vorgesehen ist, das die Hochspannungselektrode und die Meßteiler-Widerstandsanordnung wenigstens teilweise umschließt, daß die Meßteiler-Widerstandsanordnung an dem Isolierteil befestigt ist und daß auf der Außenseite des Isolierteils die Meßelektrode aufgebracht ist. Das Isolierteil gewährleistet eine einfache Montage und ermöglicht eine wohl definierte räumliche Zuordnung zwischen den Elektroden und der Meßteiler-Widerstandsanordnung.

Die Erfindung wird nachstehend anhand der Zeichnungen näher erläutert. Es zeigen:
Fig. 1 einen Schnitt durch einen Teil eines Hochspannungserzeugers
Fig. 2 einen Schnitt längs der Linie A-A' in Fig. 1 und
Fig. 3 ein Ersatzschaltbild des Hochspannungsmeßteilers

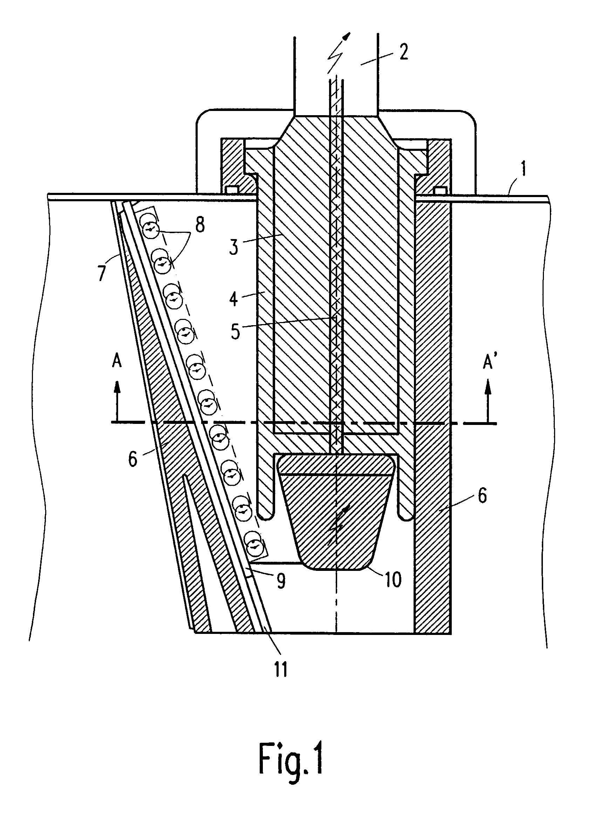

Fig. 1 stellt eine Hochspannungseinheit in Form eines Hochspannungserzeugers für einen Röntgengenerator dar. Die Zeichnung zeigt nur einen Teil des Hochspannungserzeugers, und zwar eine aus Metall bestehende geerdete Wand 1 eines Gehäuses, das alle Komponenten des Hochspannungserzeugers einschließlich der flüssigen oder gasförmigen Isoliermedien einschließt. Die erzeugte Hochspannung wird über (wenigstens) ein Kabel 2 nach außen geführt, das über eine Hochspannungssteckverbindung an den Hochspannungserzeuger angeschlossen ist.

Die Hochspannungssteckverbindung umfaßt einen mit dem Kabel 2 verbundenen zylinderförmigen Hochspannungsstecker 3 und eine mit der Wand 1 fest verbundene hohlzylindrische Hochspannungsbuchse 4, deren innere Abmessungen den äußeren Abmessungen des Hochspannungssteckers 3 angepaßt sind. Im Zentrum des Hochspannungssteckers 3 befindet sich eine Hochspannungsleitung 5 (oder mehrere Leitungen auf annähernd dem gleichen Hochspannungspotential), die durch den Boden der Hochspannungsbuchse hindurch mit den übrigen, nicht näher dargestellten Komponenten im Innern des Hochspannungserzeugers in Verbindung steht. Die Hochspannungsleitung 5 wird nachfolgend auch als Hochspannungselektrode bezeichnet. Über das Kabel 2 (und ggf. über ein weiteres Kabel, das eine Hochspannung mit entgegengesetzter Polarität führt) ist ein nicht näher dargestellter Röntgenstrahler an den Hochspannungserzeuger angeschlossen. Der Hochspannungserzeuger ist zusammen mit der ihn speisenden Niederspannungseinheit Teil eines Röntgengenerators.

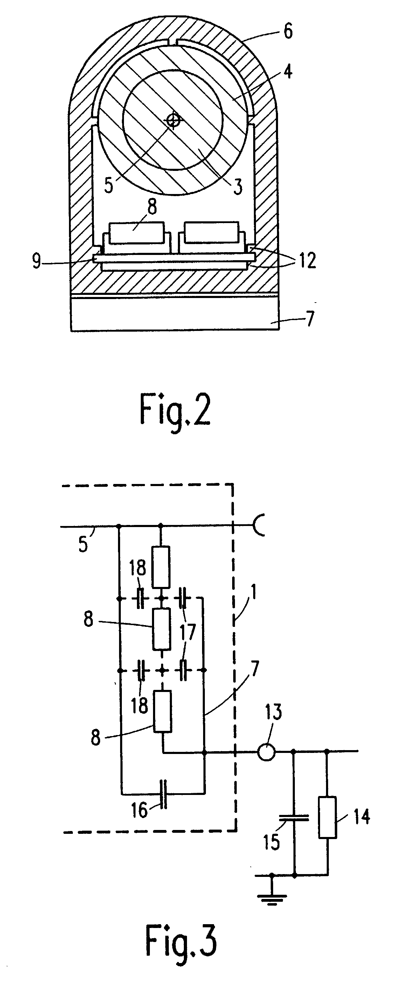

Wie die Figuren 1 und 2 zeigen, wird die Hochspannungssteckverbindung - wenigstens teilweise - von einem Isolierteil 6 umschlossen. Das Isolierteil 6 kann aus einem Duro- oder Thermoplasten, z.B. Polycarbonat, bestehen. Auf einem mit einer leichten Neigung zur Hochspannungsteckverbindung 3,4 verlaufenden Teil der Außenwand des Isolierteils 6 befindet sich eine Meßelektrode 7, an der sich im Betriebszustand ein Potential einstellt, dessen zeitlicher Verlauf weitgehend identisch mit dem zeitlichen Verlauf des Hochspannungspotentials auf der Hochspannungselektrode 5 ist, das jedoch um einen Faktor von z.B. 20 000 niedriger ist als das Potential der Hochspannungselektrode 5. Zwischen der Gehäusewand 1 und der Meßelektrode 7 herrscht im Betrieb also eine Spannung von wenigen Volt.

Zwischen dem Hochspannungsleiter 5 und der Meßelektrode 7 bildet sich im Betriebszustand ein elektrisches Feld aus. In diesem felderfüllten Raum befindet sich eine Meßteiler-Widerstandsanordnung. Diese besteht bei einer für 110 kV bestimmten Ausführungsform aus 2 x 10 elektrisch in Serie geschalteten diskreten Widerständen 8 von z. B. jeweils 26,7 MOhm. Der eine Anschluß dieser Widerstandskette ist mit der Hochspannungselektrode 5 und der andere Anschluß mit der Meßelektrode 7 verbunden. Die Widerstände 8 sind zickzackförmig auf einer Leiterplatte 9 angeordnet, die gegenüber den Elektroden 5 und 7 so geneigt ist, daß das an die Meßelektrode 7 angeschlossene Ende dichter an der Meßelektrode und das an die Hochspannungselektrode angeschlossene Ende dichter an der Hochspannungselektrode liegt als das andere Ende. Dadurch soll erreicht werden, daß die Spannungsverteilung längs der Meßteiler-Widerstandsanordnung möglichst genau mit der Feldverteilung zwischen Hochspannungselektrode 5 und Meßelektrode 7 übereinstimmt. Diesem Zweck dient auch eine das Hochspannungspotential führende, mit dem Leiter 5 verbundene glockenförmige Schirmelektrode 10, die am Ende der Hochspannungssteckverbindung und im Bereich des mit ihr verbundenen Endes der Meßteiler-Widerstandsanordnung die dielektrische Feldstärke auf einen definierten Wert herabsetzt. Die Leiterplatte 9 ist in eine Nut 11 am Isolierteil 6 eingeführt, die zwischen zwei sich in Längsrichtung erstreckenden Vorsprüngen 12 am Isolierteil 6 gebildet wird.

Fig. 3 zeigt das Ersatzschaltbild des Hochspannungsmeßteilers. Die Meßelektrode 7 ist mit einem Meßpunkt 13 leitend verbunden, der über einen Fußpunkt-widerstand aus einem ohmschen Widerstand 14 und einem dazu parallelen Kondensator 15 an Erde angeschlossen ist. Der Widerstand 14 ist um einen Faktor 1000 kleiner als jeder der zwanzig Widerstände 8, so daß sich (für Gleichstrom) ein Spannungsteilerfaktor von 1:20 000 ergibt. Wenn an der Elektrode 5 eine Spannung von beispielsweise maximal 110 kV anliegt, dann liegt demnach eine Spannung von 5,5 V am Meßpunkt 13 an. Der Fußpunkt-widerstand 14,15 kann außerhalb des Hochspannungserzeugers angeordnet sein, wobei die an ihm abgegriffene Spannung einem nicht näher dargestellten Verstärker zugeführt wird.

Der Kondensator 15 ist so bemessen, daß sich für hohe Frequenzen, bei denen der kapazitive Strom groß im Vergleich zu dem Strom über die ohmschen Widerstände 8 ist, der gleiche Teilerfaktor ergibt wie für Gleichspannung. Der kapazitive Strom wird im wesentlichen durch die Kapazität 16 bestimmt, die sich zwischen der Hochspannungselektrode 5 und der Meßelektrode 7 ergibt.

Daneben gibt es noch parasitäre Kapazitäten 17 zwischen der Meßteiler-Widerstandsanordnung 8 und der Meßelektrode 7 sowie parasitäre Kapazitäten 18 zwischen der Meßteiler-Widerstandsanordnung 8 und der Hochspannungselektrode 5. Im Idealfall - nämlich dann, wenn die Meßteiler-Widerstandsanordnung so in dem elektrischen Feld zwischen den Elektroden 5 und 7 angeordnet ist, daß die Spannungsverteilung längs der Meßwiderstands-Anordnung 8 der Potentialverteilung zwischen den Elektroden 5 und 7entspricht, sind die Ströme über die Kapazitäten 17 und 18 entgegengesetzt gleich, die über diese Kapazitäten fließenden Ströme haben dann keinen Einfluß auf die Spannungsverteilungen der Meßteiler-Widerstandsanordnung. Dieser Idealfall läßt sich in der Praxis aber nur schwer realisieren. Um den störenden Einfluß dieser Kapazitäten auf den Frequenzgang klein zu halten, sollte die Kapazität 16 möglichst groß sein. Die Kapazität 16 kann - falls erforderlich - dadurch vergrößert werden, daß die Meßelektrode 7 sich über einen größeren Teil der Außenfläche des Isolierteils 6 erstreckt; erforderlichenfalls kann die Meßelektrode die gesamte Außenfläche bedecken.

Von Vorteil ist, daß die Meßelektrode 7 die Meßteiler-Widerstandsanordnung 8 gegen Erde hin abschirmt. Es gibt daher nicht - wie bei dem Meßteiler nach der EP-OS 118 147 parasitäre Kapazitäten zwischen der Widerstandsordnung 8 und Erde sondern nur zwischen dieser Anordnung und der Meßelektrode 7. Deshalb fließen die Ströme über diese parasitären Kapazitäten nicht über das Gehäuse 1 ab, sondern über die Meßelektrode 7 und damit auch über den Fußpunktswiderstand 14,15. Sie gehen also in die Messung ein.

Ein weiterer Vorteil der Erfindung ist, daß eine ohnehin im Hochspannungserzeuger erforderliche, Hochspannung führende Komponente zugleich als Hochspannungselektrode für den Meßteiler dient, was die Kosten und den Platzbedarf reduziert. Darüberhinaus ist im Vergleich zu dem Spannungsteiler nach der DE-PS 37 14 945 von Vorteil, daß die Hochspannungselektrode 5 im Inneren des Hochspannungsmeßteilers und nicht außen liegt. Die Abstände gegenüber den nicht die gleiche Hochspannung führenden Komponenten im Innern des Hochspannungserzeugers können daher verringert werden. Darüberhinaus reduziert die Meßelektrode die von der Hochspannungselektrode ausgehenden elektromagnetisch abgestrahlten Einstreuungen in andere Leitungen und Komponenten.

Anstelle der Hochspannungssteckverbindung könnte auch eine andere im Hochspannungserzeuger ohnehin erforderliche, Hochspannung führende Komponente verwendet werden. Die Hochspannungsteckverbindung 3,4 hat jedoch den Vorteil, daß die Isolation der Hochspannungselektrode schon vorhanden ist, d.h. zwischen der Meßteiler-Widerstandsanordnung 8, insbesondere ihrem mit der Meßelektrode 7 verbundenen Ende und der Hochspannungselektrode muß keine zusätzliche Isolierung vorgesehen sein.

Statt eine Kette von diskreten Widerständen 8, kann die Meßwiderstands-Anordnung auch eine auf der Platte 9 aufgebrachte Dickschichtschaltung oder Dünnschichtschaltung umfassen.

Der Hochspannungsteiler kann in seinem Fußpunkt, d.h. zwischen dem Meßpunkt und Erde, anders beschaltet sein als in Fig. 3 dargestellt. Beispielsweise kann dem RC-Glied 14,15 noch ein Serien RC-Glied parallelgeschaltet sein. Bei geeigneter Dimensionierung dieses Serien-RC-Gliedes kann dadurch die Frequenzunabhängigkeit des Spannungsteiler-Faktors ggf. noch weiter verbessert werden.

## Patentansprüche

1. Hochspannungseinheit mit eingebautem Hochspannungsmeßteiler, der einen Meßpunkt (13) zum Abgreifen einer dem zeitlichen Verlauf der Hochspannung entsprechenden Meßspannung, eine flächenhafte, das Potential des Meßpunktes führende Meßelektrode (7) und eine Meßteiler-Widerstandsanordnung (8,9) umfaßt, die zwischen der Meßelektrode (7) und einer im Betriebszustand Hochspannung führenden Hochspannungselektrode (5) - gegenüber diesen Elektroden geneigt - angeordnet ist,
dadurch gekennzeichnet, daß als Hochspannungselektrode für den
Hochspannungsmeßteiler eine in der Hochspannungseinheit ohnehin vorgesehene Komponente (5) dient, die neben ihrer Funktion in dem Hochspannungsmeßteiler zusätzlich eine Funktion in der Hochspannungseinheit aufweist, und daß die parallel zur Meßteiler-Widerstandsanordnung wirksame Kapazität (16) durch die Kapazität zwischen der Meßelektrode (7) und der Hochspannungselektrode (5) gegeben ist.

2. Hochspannungseinheit nach Anspruch 1,
dadurch gekennzeichnet, daß die Meßteiler-Widerstandsanordnung (8, 9) durch eine Platte (9) mit einer darauf angebrachten Widerstandsanordnung gebildet wird und daß sich das eine Ende der Platte (9) in der Nähe der Hochspannungselektrode (5) und das andere Ende der Platte in der Nähe der Meßelektrode befindet.

3. Hochspannungseinheit nach Anspruch 2,
dadurch gekennzeichnet, daß die Meßteiler-Widerstandsanordnung aus einer Anzahl in Serie geschalteter diskreter Widerstände (8) besteht.

4. Hochspannungseinheit nach Anspruch 1,
dadurch gekennzeichnet, daß die Meßteiler-Widerstandsanordnung eine Dünn- oder Dickschichtschaltung umfaßt.

5. Hochspannungseinheit nach einem der vorgehenden Ansprüche, die mit wenigstens einer Hochspannungssteckverbindung zum Anschluß eines Hochspannungskabels (2) an die Hochspannungseinheit versehen ist,
dadurch gekennzeichnet, daß die Meßteiler-Widerstandsanordnung (8, 9) sich zwischen der Hochspannungssteckverbindung (5) und der Meßelektrode (7) befindet.

6. Hochspannungssteckverbindung nach Anspruch 5,
dadurch gekennzeichnet, daß sich am Ende der Hochspannungssteckverbindung (5) eine das Hochspannungspotential führende glockenförmige Schirmelektrode (10) befindet und daß die Meßteiler-Widerstandsanordnung zu der Schirmelektrode hin geneigt ist.

7. Hochspannungseinheit nach einem der vorhergehenden Ansprüche,
dadurch gekennzeichnet, daß ein Isolierteil (6) vorgesehen ist, das die Hochspannungselektrode (5) und die Meßteiler-Widerstandsanordnung (8, 9) wenigstens teilweise umschließt, daß die Meßteiler-Widerstandsanordnung (8, 9) an dem Isolierteil (6) befestigt ist und daß auf der Außenseite des Isolierteils (6) die Meßelektrode (7) aufgebracht ist.

## Claims

1. A high-voltage unit with a built-in high-voltage measuring divider which comprises a measuring point (13) deriving a measuring voltage which corresponds to the variation in time of the high voltage, a flat measuring electrode (7) which carries the potential of the measuring point, and a measuring divider/resistor arrangement (8, 9) which is arranged between the measuring electrode (7) and a high-voltage electrode (5), carrying high voltage in the operating condition, so as to be inclined relative to these electrodes, characterized in that the high-voltage electrode for the high voltage measuring divider is formed by a component (5) which is already present in the high-voltage unit and performs a function in the high-voltage unit in addition to its function in the high-voltage measuring divider, and that the capacitance (16) acting parallel to the measuring divider/resistor arrangement is given by the capacitance between the measuring electrode (7) and the high-voltage electrode (5).

2. A high-voltage unit as claimed in Claim 1, characterized in that the measuring divider/resistor arrangement (8, 9) is formed by a board (9) on which a resistor arrangement is provided, one end of the board (9) being situated in the vicinity of the high-voltage electrode (5) whereas the other end of the board is situated in the vicinity of the measuring electrode.

3. A high-voltage unit as claimed in Claim 2, characterized in that the measuring divider/resistor arrangement consists of a number of series-connected discrete resistors (8).

4. A high-voltage unit as claimed in Claim 1, characterized in that the measuring divider/resistor arrangement comprises a thick-film or thin-film circuit.

5. A high-voltage unit as claimed in one of the preceding Claims which is provided with at least one high-voltage connector for connecting a high-voltage cable (2) to the high-voltage unit, characterized in that the measuring divider/resistor arrangement (8, 9) is situated between the high-voltage connector (5) and the measuring electrode (7).

6. A high-voltage unit as claimed in Claim 5, characterized in that at the end of the high-voltage connector (5) there is provided a bell-shaped shielding electrode (10) which carries the high-voltage potential, and that the measuring divider/resistor arrangement is inclined towards the shielding electrode.

7. A high-voltage unit as claimed in one of the preceding Claims, characterized in that there is provided an insulating member (6) which at least partly encloses the high-voltage electrode (5) and the measuring divider/resistor arrangement (8, 9) that the measuring divider/resistor arrangement (8, 9) is connected to the insulating member (6), and that the measuring electrode (7) is provided on the external surface of the insulating member (6).

## Revendications

1. Unité à haute tension avec un diviseur de mesure à haute tension intégrée qui comprend un point de mesure (13) en vue du prélèvement d'une tension de mesure correspondant au tracé temporel de la haute tension, une électrode de mesure plane qui conduit le potentiel du point de mesure (7) et un dispositif de résistance de diviseur de mesure (8, 9) qui est disposé entre l'électrode de mesure (7) et une électrode à haute tension (5) conduisant une haute tension à l'état de fonctionnement - inclinée par rapport à ces électrodes,
caractérisée en ce que l'électrode à haute tension pour le diviseur de mesure à haute tension est un composant (5) prévu de toute façon dans l'unité à haute tension qui, outre sa fonction dans le diviseur de mesure à haute tension, présente par ailleurs une fonction dans l'unité à haute tension et que la capacité (16) active parallèlement au dispositif de résistance du diviseur de mesure est obtenue par la capacité entre l'électrode de mesure (7) et l'électrode à haute tension (5).

2. Unité à haute tension selon la revendication 1,
caractérisée en ce que le dispositif de résistance du diviseur de mesure (7, 8, 9) est formé par une plaque (9) avec un dispositif de résistance appliqué sur celle-ci et que l'une des extrémités de la plaque (9) se trouve à proximité de l'électrode à haute tension (5) et l'autre extrémité de la plaque à proximité de l'électrode de mesure.

3. Unité à haute tension selon la revendication 2,
caractérisée en ce que le dispositif de résistance du diviseur de mesure se compose d'une série de résistances (8) discrètes montées en série.

4. Unité à haute tension selon la revendication 1,
caractérisée en ce que le dispositif de résistance du diviseur de mesure comprend un circuit en couche mince ou en couche épaisse.

5. Unité à haute tension selon l'une des revendications précédentes qui est dotée d'au moins un connecteur à fiche à haute tension en vue du raccordement d'un câble à haute tension (2) à l'unité à haute tension, caractérisée en ce que le dispositif de résistance du diviseur de mesure (8, 9) se trouve entre le connecteur à fiche à haute tension (5) et l'électrode de mesure (7).

6. Connexion à fiche à haute tension selon la revendication 5,
caractérisée en ce qu'une électrode d'écran en forme de cloche conduisant le potentiel à haute tension (10) se trouve à l'extrémité du connecteur à fiche à haute tension (5) et que le dispositif de résistance d'un diviseur de mesure est incliné par rapport à l'électrode d'écran.

7. Unité à haute tension selon l'une des revendications précédentes,
caractérisée en ce qu'une pièce isolante (6) est prévue et renferme, du moins partiellement, l'électrode à haute tension (5) et le dispositif de résistance du diviseur de mesure (8, 9), que le dispositif de résistance du diviseur de mesure (8,9) est fixé sur la pièce isolante (6) et que l'électrode de mesure (7) est appliquée sur la face externe de la pièce isolante (6).
